# EUROPEAN PATENT APPLICATION

(11) **EP 3 618 218 A1**
(43) Date of publication of application: **04.03.2020**
(21) Application number: 17906940.6
(22) Date of filing: 27.12.2017
(51) Int. Cl.: H02J 7/00, G01R 31/02, G01R 31/36, H01M 10/48, H02J 7/02

(54) **POWER SUPPLY SYSTEM, FAULT DIAGNOSIS METHOD FOR POWER SUPPLY SYSTEM, AND SYSTEM CONTROL DEVICE**

(30) Priority: 27.04.2017 JP 2017088106
(71) Applicant: Envision AESC Japan Ltd., Kanagawa 2520012 (JP)
(72) Inventor: HAYASHI, Kazuomi, Zama-shi, Kanagawa 252-0012 (JP)
(74) Representative: Santarelli
(86) International application number: PCT/JP2017/047046
(87) International publication number: WO 2018/198437

(57) **Abstract**

The purpose of the present invention is to reduce a diagnosis time. A power supply system (10, 20, 30, 40) has: battery devices (13, 23, 33, 43); switches (14, 24, 34, 44) connected in series to the respective battery devices; and voltmeters (15, 25, 35, 45) for measuring the voltages of circuits composed of the respective battery devices and switches. A device for controlling the power supply system in which power supply devices (10, 20, 30, 40) are connected in parallel turns on the switch of at least one power supply device and performs fault diagnosis on the basis of the voltage values of the power supply devices to which the switches in an off state belong.

## Description

### TECHNICAL FIELD

The present disclosure relates to a power supply system, a fault diagnosis method for a power supply system, and a system control device.

### BACKGROUND

As a conventional power supply system, the configuration described in Patent Document 1 is known. This power supply system has a configuration in which a plurality of power supply devices is connected in parallel to a load. Before the startup of the power supply system, the switch installed in each of the power supply devices is turned on and off for each of the power supply devices to diagnose the presence or absence of a disconnection abnormality.

### [Prior Art Document]

### Patent Document

Patent Document 1: Japanese laid-open publication No. 2012-034535

### SUMMARY

However, since the on/off operation of the switch installed in each of the power supply devices is repeated for each of the power supply devices, if the number of power supply devices increases, the diagnosis time becomes longer. The present disclosure provides some embodiments of a technique capable of shortening the diagnosis time.

According to one embodiment of the present disclosure, there is provided a power supply system, including: a power supply group in which a plurality of power supply devices is connected in parallel to a load; and a system control part configured to control the power supply group, wherein each of the power supply devices includes a battery device, a switching part connected in series to the battery device and configured to be switched between connection and disconnection, and a voltage detection part configured to detect a voltage of the battery device, and wherein the system control part is configured to switch the switching part of at least one of the power supply devices to a connection state, and perform fault diagnosis based on a voltage value detected by the voltage detection part of a power supply device, among the plurality of power supply devices, whose switching part is not switched to the connection state.

According to the present disclosure, it is possible to shorten the fault diagnosis time.

### BRIEF DESCRIPTION OF DRAWINGS

FIG. 1 is a block diagram of a power supply system according to a first embodiment.
FIG. 2 shows an example of an electrical contact structure of the first embodiment.
FIG. 3 is a flowchart in the power supply system shown in FIG. 1.
FIG. 4 is a flowchart in the power supply system shown in FIG. 1.
FIG. 5 is a view for comparing a first embodiment with a comparative example.
FIG. 6 is a view for comparing a second embodiment with a comparative example.
FIG. 7 is a view for explaining a diagnosis route of the second embodiment.

### DETAILED DESCRIPTION

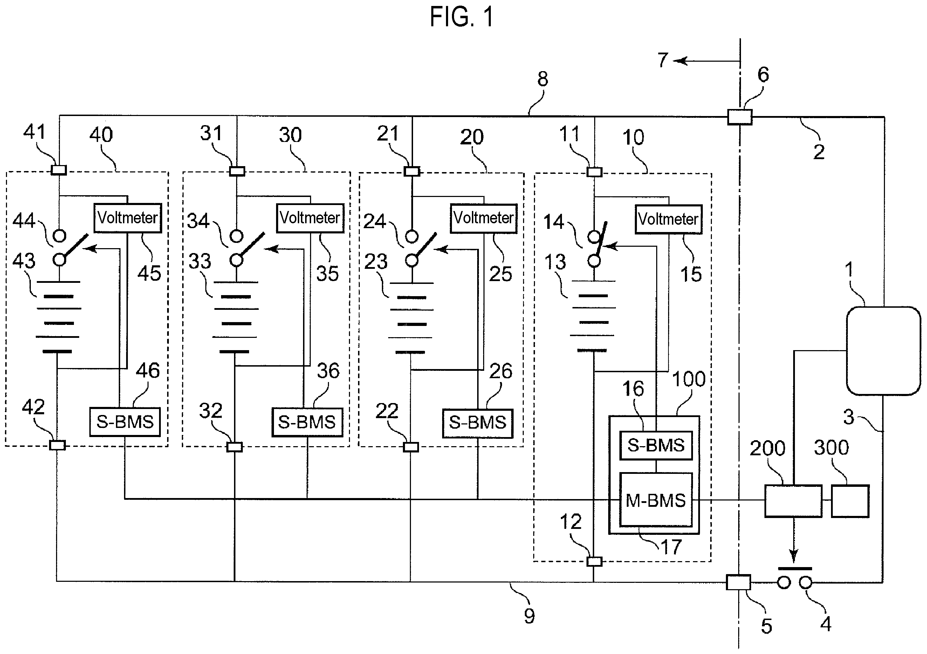

A power supply system according to a first embodiment will be described with reference to the drawings. First, each component and function will be described using a block diagram of FIG. 1.
Reference numeral 1 denotes a load/regeneration device, for example, an inverter and a motor mounted on a vehicle. Electric power is supplied from a power supply device to the motor via the inverter. Vehicle wheels are rotated by the rotation of the motor to cause the vehicle to travel. Furthermore, the electric power generated by the regenerative braking of the motor is supplied to the power supply device.

Reference numeral 2 denotes a high voltage side heavy current harness connected to the load/regeneration device 1, and reference numeral 3 denotes a low voltage side heavy current harness connected to the load/regeneration device 1. Reference numeral 4 denotes a relay. In FIG. 1, one end of the relay 4 is connected to the low voltage side heavy current harness 3. Reference numeral 5 denotes a fitting type connector. One of two fitted connector parts of the fitting type connector 5 is connected to the other end of the relay 4. Reference numeral 6 denotes a fitting type connector which is the same as the fitting type connector 5. One of two connector parts of the fitting type connector 6 is connected to the load/regeneration device 1 via the high voltage side heavy current harness 2.

Reference numeral 7 denotes a battery group. The battery group 7 includes a high voltage side heavy current harness 8 connected to the other connector part of the connector 6, a low voltage side heavy current harness 9 connected to the other connector part of the connector 5, and four power supply devices 10, 20, 30 and 40. The power supply devices 10, 20, 30 and 40 have substantially the same configuration and are connected in parallel to the load/regeneration device 1.

Hereinafter, the power supply device 10 will be described as an example. The power supply device 10 includes an electrical contact 11 connected to the harness 8, an electrical contact 12 connected to the harness 9, a battery device 13 having a plurality of unit cells connected in series and having a negative terminal connected to the electrical contact 12, a switch 14 having one end connected to the positive end of the battery device 13 and the other end connected to the electrical contact 11, a voltmeter 15 configured to measure a voltage difference between a voltage between the electrical contact 11 and the switch 14 and a voltage between the electrical contact 12 and the negative terminal of the battery device 13, and a slave BMS (Battery Management System) 16 configured to receive a voltage value measured by the voltmeter 15, transmit the received voltage value to a master BMS (Battery Management System) 17 described later and control switching of an on (closed) state and an off (open) state of the switch 14 according to an instruction from the master BMS 17. In the figures, the slave BMS is denoted as S-BMS and the master BMS is denoted as M-BMS. In the first embodiment, the master BMS 17 as a system control part and the slave BMS 16 as a battery control part are configured by one control unit 100.

In FIG. 1, the parts 21 to 26 of the power supply device 20 and their connection relationship, the parts 31 to 36 of the power supply device 30 and their connection relationship, and the parts 41 to 46 of the power supply device 40 and their connection relationship are the same as the parts 11 to 16 of the power supply device 10 and their connection relationship. Therefore, the description thereof will be omitted. The difference lies in that the master BMS 17 as a part of the control unit 100 of the power supply device 10 is not included in other power supply devices. The slave BMSs 26, 36, 46 are connected to the control unit 100 (the functional part of the master BMS 17) of the power supply device 10.

Next, reference numeral 200 denotes a VCU (Vehicle Control Unit) which is connected to the load/regeneration device 1, the relay 4, the control unit 100 and an ignition switch (not shown) or a sensor (vehicle speed sensor or the like) 300 for inputting a vehicle status signal. Upon receiving the state of the ignition switch, the VCU 200 performs a startup process of the VCU 200 itself, issues a startup command to the master BMS 17 of the control device 100, and instructs the respective slave BMSs 16, 26, 36 and 46 to turn on (close) the switches 14, 2, 43 and 44.

When the VCU 200 receives a notification indicating the completion of preparation for charge and discharge from the master BMS 17 which has received a signal indicating that all the switches 14, 24, 34 and 44 of the slave BMSs 16, 26, 36 and 46 are turned on, the VCU 200 turns on (closes) the relay 4 and starts control of charge and discharge.
The VCU 200 receives a state signal of the vehicle from the sensor 300 or receives a state signal of the battery group 7 from the master BMS 17. The VCU 200 calculates a target value to be outputted to the load/regeneration device 1 or outputs to the master BMS 17 a command to monitor the charge/discharge state of the battery group and control the charge and discharge.

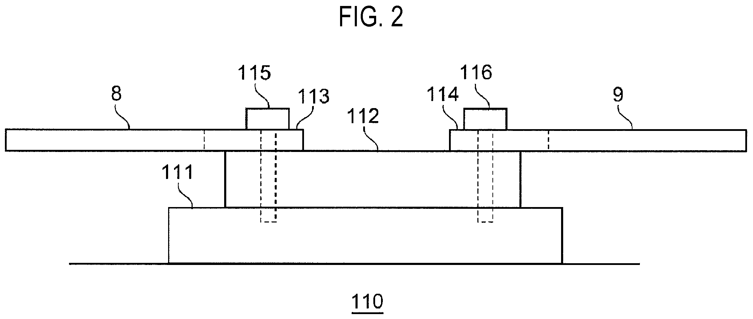

FIG. 2 shows an example of the electrical contacts 11, 12, 21, 22, 31, 32, 41 and 42. The electrical contact 11 will be described as an example. Reference numeral 111 denotes an insulating substrate 111 which is attached to, for example, a case 110 for storing the battery group 7. Reference numeral 112 denotes a metal plate which is fixed to the insulating plate 111.
Reference numeral 113 denotes a round terminal attached to one end of the harness 8, and reference numeral 114 denotes a round terminal attached to one end of the harness 9.
Reference numeral 115 denotes a metal bolt which is inserted into a hole formed in the round terminal 113 and a hole portion formed in the metal plate 112 and which is screwed to the insulating substrate 111. Reference numeral 116 denotes a metal bolt which is inserted into a hole formed in the round terminal 114 and another hole portion formed in the metal plate 112 and which is screwed into another hole portion of the insulating substrate 111.

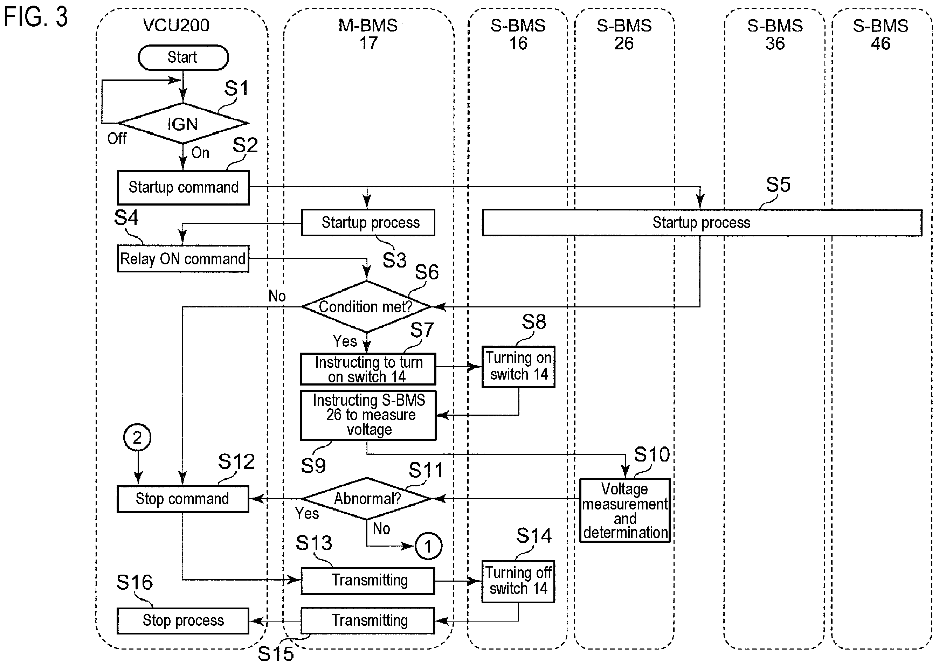

A flowchart of the power supply system according to the first embodiment will be described with reference to FIG. 3.
Step (hereinafter referred to as S) 1 is a step to determine whether or not the VCU 200 has detected the operation of the ignition switch operated by a vehicle operator at the start of travel. When the operation of the ignition switch is detected, in S2, the VCU 200 instructs the master BMS 17 and the slave BMSs 16, 26, 36 and 46 to perform a startup process.

In S3, the master BMS 17 performs transition from a sleep state to a non-sleep state as the startup process and transmits a startup completion flag to the VCU 200 after completion of the transition. In S4, the VCU 200 that has received the start completion flag from the master BMS 17 transmits a diagnosis start command to the master BMS 17.
In S5, each slave BMS performs transition from a sleep state to a non-sleep state as the startup process and transmits a startup completion flag to the master BMS 17 after completion of the transition. At this time, each slave BMS performs ON-fixed fault diagnosis and OFF-fixed fault diagnosis of the switch, and transmits the diagnosis results together with a startup completion flag.

In S6, the master BMS 17 receives a diagnosis start command from the VCU 200, receives the startup completion flag from each slave BMS, and determines whether all the switch-fixed fault diagnosis results are normal. If all the conditions are met, in S7, the switch-closing sequence for charge/discharge preparation stored in advance in the memory of the master BMS 17 is read out. In the following, in order to simplify the description, it is assumed that the switches 14, 24, 34 and 44 are turned on in the named order. If one of the conditions is not met, an abnormality signal is sent to the VCU 200 (the process proceeds to S12).

In S7, the master BMS 17 transmits an instruction to turn on the switch 14 to the slave BMS 16 of the power supply device 10. In S8, the slave BMS 16 turns on the switch 14. Thereafter, the master BMS 17 is notified of the fact that the switch 14 is in an on state. In S9, the master BMS 17 confirms whether or not the notification indicating that the switch 14 is in the on state is received from the slave BMS 16. If the notification is received, the master BMS 17 transmits an instruction signal for sending a voltage value to the slave BMS 26 of the power supply device 20 to be turned on next.

In S10, the slave BMS 26 determines whether or not the voltage value measured by the voltmeter 25 is equal to or higher than a predetermined voltage. If the voltage value is equal to or higher than the predetermined voltage, the slave BMS 26 determines that the voltage value is normal. If the voltage value is lower than the predetermined voltage, the slave BMS 26 determines that the voltage value is abnormal. The slave BMS 26 transmits a normality signal or an abnormality signal to the master BMS 17. As used herein, term "predetermined voltage" refers to a reference voltage determined by multiplying the number of unit cells by a voltage value smaller than the voltage available when the SOC (State of Charge) of the unit cells used in the power supply device is 0%. If the voltage value is equal to or higher than the reference voltage, it can be determined that there is no disconnection including a contact fault.

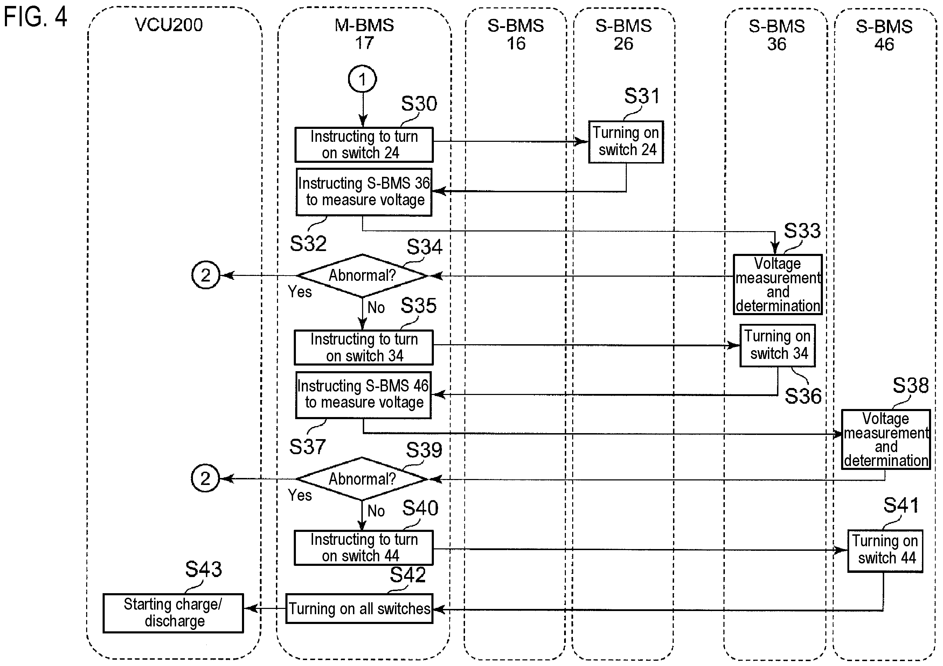

In S11, normal or abnormal information is received from the slave BMS 26 of the power supply device 20 to be secondly turned on. If it is normal, the process proceeds to S30 of FIG. 4. If it is abnormal, an abnormality signal is sent to the VCU 200. In S12, when the VCU 200 receives the abnormality signal, the VCU 200 transmits a stop command to the slave BMS 16 via the master BMS 17 (S13). Since the switch 14 is kept turned on in the above description, an instruction to turn the switch 14 off is sent to the slave BMS 16.

In S14, the switch 14 is turned off by the slave BMS 16. Thereafter, a flag indicating that the switch 14 has been turned off is transmitted to the VCU 200 via the master BMS 17 (S15). In S16, the VCU 200 executes a stop process. As the stop process, for example, an abnormality lamp is turned on an in-vehicle monitor, or the transition to a traveling mode is prohibited. Next, in S30 of FIG. 4, the master BMS 17 issues an instruction to turn on the switch 24 of the power supply device 20 to be secondly turned on.

In S31, the slave BMS 26 turns on the switch 24 and then notifies the master BMS 17 that the switch 24 is turned on. In S32, the master BMS 17 confirms whether or not the notification indicating that the switch 24 is turned on is received. If the notification is received, the master BMS 17 transmits an instruction signal for sending a voltage value to the slave BMS 36 of the power supply device 30 to be turned on next.

In S33, the slave BMS 36 determines whether or not the voltage value measured by the voltmeter 35 is equal to or higher than a predetermined voltage. If the voltage value is equal to or higher than the predetermined voltage, the slave BMS 36 determines that the voltage value is normal. If the voltage value is lower than the predetermined voltage, the slave BMS 36 determines that the voltage value is abnormal. The slave BMS 36 transmits a normality signal or an abnormality signal to the master BMS 17. As used herein, term "predetermined voltage" refers to a reference voltage determined by multiplying the number of unit cells by a voltage value smaller than the voltage available when the SOC (State of Charge) of the unit cells used in the power supply device is 0%. If the voltage value is equal to or higher than the reference voltage, it can be determined that there is no disconnection including a contact fault.

In S34, normal or abnormal information is received from the slave BMS 36 of the power supply device 30 to be thirdly turned on. If it is normal, the process proceeds to S35. If it is abnormal, an abnormality signal is sent to the VCU 200 (the process proceeds to S12). In S35, the master BMS 17 transmits to the slave BMS 36 an instruction to turn on the switch 34 of the power supply device 30 to be thirdly turned on. In S36, the slave BMS 36 turns on the switch 34 and then notifies the master BMS 17 that the switch 34 is turned on.

In S37, the master BMS 17 confirms whether or not the notification indicating that the switch 34 is turned on is received. If the notification is received, the master BMS 17 transmits an instruction signal for sending a voltage value to the slave BMS 46 of the power supply device 40 to be turned on next.
In S38, the slave BMS 46 determines whether or not the voltage value measured by the voltmeter 45 is equal to or higher than a predetermined voltage. If the voltage value is equal to or higher than the predetermined voltage, the slave BMS 46 determines that the voltage value is normal. If the voltage value is lower than the predetermined voltage, the slave BMS 46 determines that the voltage value is abnormal. The slave BMS 46 transmits a normality signal or an abnormality signal to the master BMS 17. As used herein, term "predetermined voltage" refers to a reference voltage determined by multiplying the number of unit cells by a voltage value smaller than the voltage available when the SOC (State of Charge) of the unit cells used in the power supply device is 0%. If the voltage value is equal to or higher than the reference voltage, it can be determined that there is no disconnection including a contact fault.

In S39, normal or abnormal information is received from the slave BMS 46 of the power supply device 40 to be fourthly turned on. If it is normal, the process proceeds to S40. If it is abnormal, an abnormality signal is sent to the VCU 200 (the process proceeds to S12). In S40, the master BMS 17 transmits to the slave BMS 46 an instruction to turn on the switch 44 of the power supply device 40 to be fourthly turned on. In S41, the slave BMS 46 turns on the switch 44 and then notifies the master BMS 17 that the switch 44 is turned on.

In S42, the master BMS 17 confirms that the switches of all the power supply devices are turned on, and transmits an all-switch-on signal to the VCU 200. In S43, the VCU 200 starts charge and discharge. Although not shown, the process from S12 to S16 is performed when an abnormal state occurs, for example, when the VCU 200 determines that a battery is overcharged or over-discharged during charge and discharge.

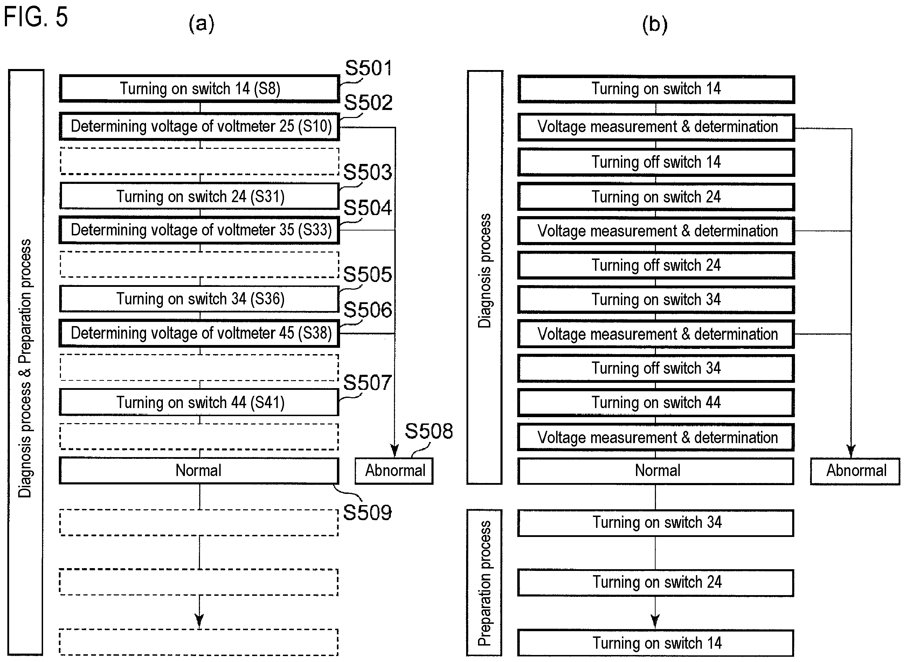

FIG. 5 shows process charts in which the diagnosis process and the charge/discharge preparation process are extracted from the flowcharts of FIGS. 3 and 4. The effects of the first embodiment will be described.
FIG. 5 (a) shows the diagnosis process of the first embodiment, and FIG. 5 (b) shows a diagnosis process of a comparative example. In any of (a) and (b) in FIG. 5, all the switches of the power supply devices are initially turned off. The preparation process is a state for starting charge and discharge and is a state in which all the switches are turned on.
The process of FIG. 5 (a) will be described. First, after the switch 14 is turned on in S501, the voltage is measured by the voltmeter 25 in S502. It is determined whether the voltage is equal to or higher than the predetermined voltage described above. Next, after the switch 24 is turned on in S503, the voltage is measured by the voltmeter 35 in S504. It is determined whether the voltage is equal to or higher than the predetermined voltage described above.
Next, after the switch 34 is turned on in S505, the voltage is measured by the voltmeter 45 in S506. It is determined whether the voltage is equal to or higher than the predetermined voltage described above. In any of the determinations, if it is determined that the voltage is smaller than the predetermined voltage, it is determined in S508 that a disconnection abnormality including a contact fault has occurred, and an abnormality process is performed. For example, the abnormality process is a process from S12 to S16 of FIG. 3. If the voltages of all the power supply devices are equal to or higher than the predetermined voltage, the remaining switch 44 is turned on in S07, and the diagnosis process and the preparation process are normally completed (S509).

In the comparative example shown in FIG. 5 (b), a voltmeter is prepared as the only one voltmeter common to the respective power supply devices as described in Patent Document 1.
FIG. 5 (b) shows a diagnosis procedure which sequentially turns on the switch, measures the voltage and turns off the switch for each power supply device.
As apparent from the comparison between (a) and (b) in FIG. 5, when comparing the diagnosis process and the preparation process as a whole, the process can be shortened because there is no process of turning off the turned-on switch and then turning on the switch again. Even when only the diagnosis process is compared, i.e., even when the process of turning on the switch kept in the off state is excluded, a disconnection fault can be diagnosed by the voltage applied other power supply devices by turning on the switch of at least one power supply device.

Furthermore, when the normality of a route is determined in S10 of FIG. 3, the switch 24 of the next power supply device 20 determined in S6 is turned on. When the normality of a route is determined in S33, the switch 34 of the next power supply device 30 determined in S6 is turned on. When the normality of a route is determined in S38, the switch 44 of the next power supply device 40 determined in S6 is turned on. Even when the switches are kept turned on in this way, the fault diagnosis can be performed using the voltage of the power supply device whose switch is in an off state. Therefore, the diagnosis itself is not affected, and the process of changing the switch from the off state to the on state in preparation for charge after diagnosis is not necessary.

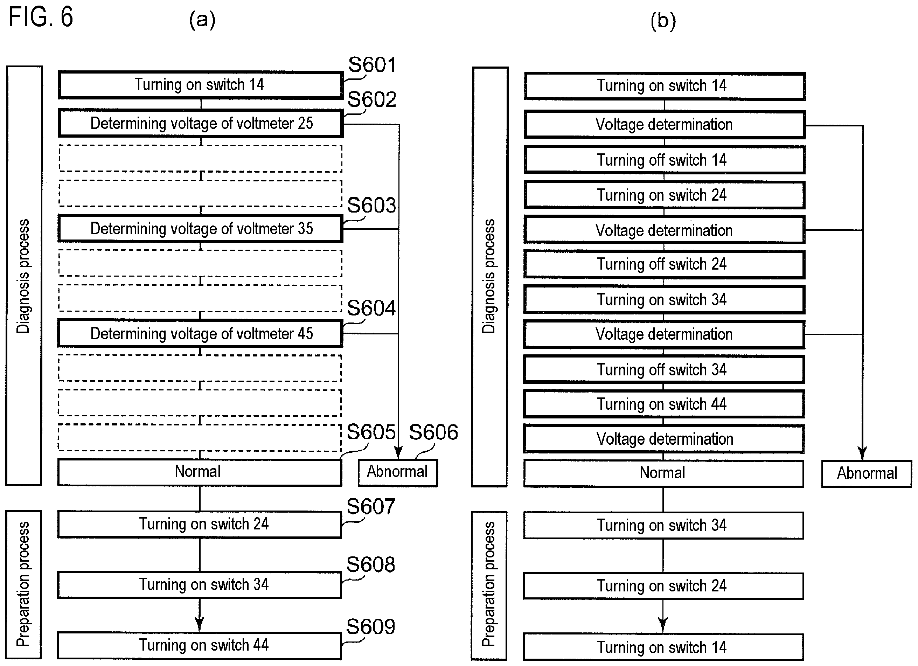

Next, a second embodiment in which the procedure shown in the process charts of FIG. 5 is changed will be described with reference to FIG. 6. The block diagram of the second embodiment is the same as that of FIG. 1 and the electrical contact structure of the second embodiment is the same as that of FIG. 2. Therefore, the description thereof will be omitted. Moreover, FIG.6 (b) shows a diagnosis process of a comparative example similar to FIG.5 (b). Furthermore, in any of (a) and (b) in FIG. 6, all the switches of the power supply devices are initially turned off.
The process of FIG. 6 (a) will be described. In step S601, the switch 14 is turned on. In step S602, a voltage value is measured by the voltmeter 25 of the power supply device 20 to which the switch 24 scheduled to be secondly turned on belongs. It is determined whether the voltage value is equal to or higher than the predetermined voltage described above.
In S603, a voltage value is measured by the voltmeter 35 of the power supply device 30 to which the switch 34 scheduled to be thirdly turned on belongs. It is determined whether the voltage value is equal to or higher than the predetermined voltage described above. In S604, a voltage value is measured by the voltmeter 45 of the power supply device 40 to which the switch 44 scheduled to be fourthly turned on belongs. It is determined whether the voltage value is equal to or higher than the predetermined voltage described above. In step S605, if the voltages of all the power supply devices are equal to or higher than the predetermined voltage, it is determined that the power supply system is normal.

In S606, when it is determined in any one of S602, S603 and S604 that the voltage value is lower than the predetermined voltage, it is determined that a disconnection abnormality including a contact fault has occurred, and an abnormality process is performed. For example, the abnormality process is the process from S12 to S16 of FIG. 3.

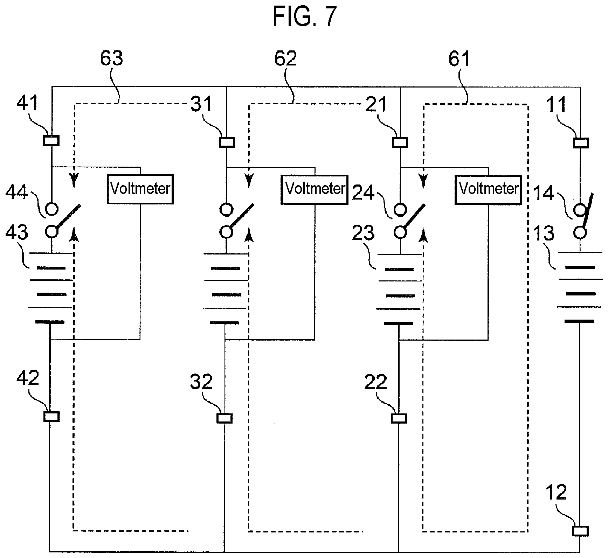

FIG. 7 is a view for explaining routes for diagnosing the presence or absence of a disconnection abnormality in the second embodiment. The route 61 is diagnosed in S601 and S602, the route 62 is diagnosed in S603, and the route 63 is diagnosed in S604. It is possible to diagnose the presence or absence of disconnection of the heavy current harness and also diagnose the presence or absence of a contact fault. In the first embodiment, the route 61 of FIG. 7 is diagnosed in S501 and S502 of FIG. 5 (a), the route 62 is diagnosed in S504, and the route 63 is diagnosed in S506.

As apparent from the comparison of (a) and (b) in FIG. 6 and FIG. 7, the route 62 can be diagnosed with the voltage value of the voltmeter 35 determined in S603, and the route 63 can be diagnosed with the voltage value of the voltmeter 45 determined in S604, without turning on the switches 24, 34 and 44 which are kept turned off. As described above, by turning on (closing) the switch of at least one of the power supply devices of the power supply group 7, a voltage can be applied to the power supply device to which the switch kept in an off state belongs. Therefore, the diagnosis of disconnection including a contact fault can be performed in a short time.

In addition, after the switch 14 of the power supply device 10 is turned on in S601 of FIG. 6, the normality of the route is determined in S602, S603 and S604, which makes it possible to perform diagnosis in a reliable manner and through a short process as compared with FIG. 5(a). Furthermore, each power supply device has a structure that includes electrical contacts at both ends of a circuit including a switch and a battery device. Therefore, it is possible to determine a contact fault at the electrical contacts.
Although two embodiments have been described above, the present disclosure is not limited thereto and may be modified without departing from the scope of the present disclosure. For example, in FIG. 1, the master BMS 17 is configured by the same CPU as that of the slave BMS of the power supply device 10. Alternatively, the master BMS 17 and the slave BMS may be configured by different CPUs.

Furthermore, although the transmission of signals from the master BMS 17 to the slave BMSs 26, 36 and 46 is performed by serial communication in the above description, it may be possible to use parallel communication in which the master BMS 17 independently communicates with the slave BMSs 26, 36 and 46. There may be or may not be a case for storing the battery group 7. There may be or may not be a case for storing the power supply device. The master BMS 17 is not essential and the VCU may serve as the master BMS 17.

Furthermore, the load/regeneration device 1 is not limited to the vehicle drive motor or the inverter and may be a power load of a stationary power supply device other than a moving body. Moreover, although there has been described the example in which the relay 4 is arranged on the low voltage side, the relay 4 may be arranged on the high voltage side, or may be on both the high voltage side and the low voltage side. Furthermore, the relay 4 may be omitted. Although there has been described the example in which the battery device 13 includes unit cells connected in series, the unit cells may be connected in series and in parallel, or may be connected in parallel.

Furthermore, the connection relationship is not limited to that shown in FIG. 1. Necessary electrical circuit components may be appropriately disposed midway by, for example, adding a thermometer for detecting the temperature of the unit cells or the battery device 13, an ammeter for detecting a current flowing through the battery device 13, and a fuse.
In addition, as an example of the electrical contacts, there have been described the electrical contacts 11, 12, 21, 22, 31, 32, 41 and 42 provided at both ends of the circuit including the switch of each power supply device and the battery device as shown in FIG. 2. However, the electrical contacts may be fitting type connectors. In this case, a storage case may be prepared for each battery device, one connector part of the fitting type connector may be attached to the case, and the other connector part may be connected to the harness 8.

### EXPLANATION OF REFERENCE NUMERALS

1: load/regeneration device
7: power supply group
10, 20, 30, 40: power supply device
13, 23, 33, 34: battery device
17: master BMS (system control part)
16, 26, 36, 46: slave BMS (battery control part)
14, 24, 34, 44: switch (switching part)
15, 25, 35, 45: voltmeter (voltage detection part)
100: control unit
200: VCU

## Claims

1. A power supply system, comprising:
a power supply group in which a plurality of power supply devices is connected in parallel to a load; and
a system control part configured to control the power supply group,
wherein each of the power supply devices includes a battery device, a switching part connected in series to the battery device and configured to be switched between connection and disconnection, and a voltage detection part configured to detect a voltage of the battery device, and
wherein the system control part is configured to switch the switching part of at least one of the power supply devices to a connection state, and perform fault diagnosis based on a voltage value detected by the voltage detection part of a power supply device, among the plurality of power supply devices, whose switching part is not switched to the connection state.

2. A fault diagnosis method for a power supply system in which a plurality of power supply devices is connected in parallel to a load, each of the power supply devices including a battery device, a switching part connected in series to the battery device and configured to be switched between connection and disconnection, and a voltage detection part configured to detect a voltage of the battery device,
wherein after switching the switching part of at least one of the power supply devices to a connection state, fault diagnosis is performed based on a voltage value detected by the voltage detection part of a power supply device, among the plurality of power supply devices, whose switching part is not switched to the connection state.

3. A system control device for controlling a power supply group in which a plurality of power supply devices is connected in parallel, each of the power supply devices including a battery device, a switching part connected in series to the battery device and configured to be switched between connection and disconnection, and a voltage detection part configured to measure a voltage between both ends of a circuit including the battery device and the switching part,
wherein the system control device is configured to switch the switching part of at least one of the power supply devices to a connection state, and perform fault diagnosis based on a voltage value of a power supply device, among the plurality of power supply devices, whose switching part is not switched to the connection state.
